# EUROPEAN PATENT APPLICATION

(11) **EP 1 119 001 A1**
(43) Date of publication of application: **25.07.2001**
(21) Application number: 00440014.9
(22) Date of filing: 21.01.2000
(51) Int. Cl.: G11C 7/16

(54) **Portable audio unit**

(71) Applicant: ALCATEL, 75008 Paris (FR)
(72) Inventor: Loeuillet, Patrick, 67200 Strasbourg (FR)
(74) Representative: Brose, Gerhard

(57) **Abstract**

The invention relates to a portable audio unit with several components (6, 7), in particular battery, processor, input means and loudspeaker. In order to realize a broad field of application, at least two audio functions are provided which are realized, in part by the same components (6, 7).

## Description

The invention relates to a portable audio unit according to the preamble to Claim 1. The term 'audio unit' here is to be understood to encompass all units in the widest sense that are suitable for acoustic reproduction of audio signals stored on a data carrier or received by radio. These include, for example, radiotelephones, dictating machines, Walkman units, audio car players and MP3 players. Audio units of this type are frequently only utilized sporadically. Transportation of the units may be found to be extremely tiresome, particularly during phases when they are not being used. This effect is particularly pronounced if several audio units, for example a mobile phone and a Walkman, are being carried around simultaneously.

The object underlying the invention is to create a portable audio unit that, while having a compact structure, is distinguished by high functionality.

In accordance with the invention this object is achieved by virtue of the characterizing features of Claim 1. Dual or multiple utilization of the components that are present in every audio unit results in increased functionality with simultaneous simplification and cost-reduction in comparison with the traditional individual units. The user of a universal unit according to the invention has to use just one unit in order to satisfy entirely different needs. The tiresome carrying-around of several units, on a belt-type holder for example, is rendered unnecessary. The ease of transportation is improved furthermore by virtue of a reduced weight of the universal unit in comparison with individual units. Known portable audio units always have a battery and a loudspeaker, so that at least these two components, which are the most elaborate with regard to space requirement and manufacturing costs, can be utilized for various applications. In addition, processor, input means, volume control, screen, interface and other components may be included in this multiple utilization.
In this way, within the scope of the invention diverse combinations of various audio functions are possible in one universal unit. With a view to practical realization of such a universal unit, the starting-point may be an extant audio unit which is upgraded with the specific components, for example a data carrier or a radio-reception modem.

Claim 2 characterizes an embodiment in which Walkman and MP3-player functions are combined in one portable audio unit. The Walkman function may be realized by any type of Walkman, for example a portable radio receiver, a cassette playback unit or a CD playback unit. MP3 stands for MPEG (Moving Picture Experts Group) 1, Layer III and is based on a data-reduction size, by virtue of which a very large amount of data, for example digitized music, is capable of being stored on a data carrier with little storage space, on a so-called flash memory card. MP3 technology and the new audio compressed standard or future standard enables the downloading of audio files from Internet websites, but also the conversion of CD files into space-saving MP3 files. Special chips serve as storage media, the carrier of which is the flash memory card. In order to make the flash memory card virtually audible, a data decompression, by means of a Winamp program for example, into the standard wav format is required. A program tool of this type is the only essential component specific to the MP3 player. All the other components, such as battery, volume control, screen, interface and loudspeaker, inclusive of signal processing, coincide with the Walkman components. In case the Walkman takes the form of a portable CD player, the multi-purpose unit consequently enables the playback both of CDs and of flash memory cards. The particular advantage is that two separate and expensive playback units are no longer required in order to be able to hear "Internet music" and CD music in portable manner.

According to Claim 3 a combination of mobile-phone and MP3-player functions is provided. An MP3-player/mobile-phone results by virtue of measures analogous to those with respect to the MP3-player/Walkman described in detail above. Additional it is possible to download MP3 files using the GSM network. With a large LCD Screen and an easy to use men-machine-interface of a WAP mobile phone it is easy to choose a song. After selecting a song the network can recognize the phone number and add the costs to the month's bill.

The MP3-player components in this case comprise, according to Claim 4, receiving means for insertion of the flash memory card and matching means for decompression of the data stored on the flash memory card into a format that is capable of being played back. The matching means may be realized by a Winamp tool, for example, as a result of which the decompression of the data pertaining to the flash memory card is effected into the wav format by way of format that is capable of being played back.

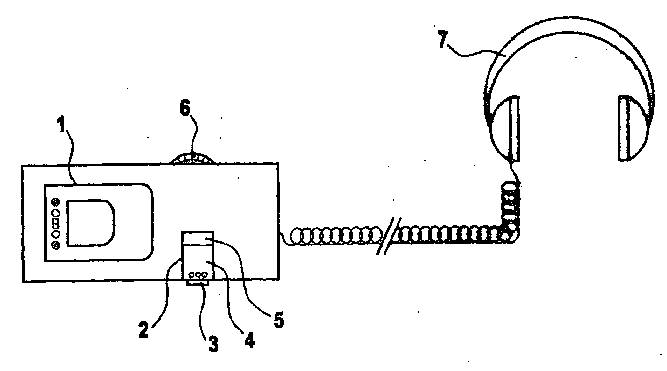

The invention is elucidated in more detail in the following on the basis of an embodiment example which is represented in the Figure.

The Figure shows a considerably schematized representation of a portable audio unit with Walkman and MP3-player functions. The Walkman contains the specific components 1 of a CD player. In addition, the audio unit is equipped with the specific components 2 of an MP3 player. The latter components substantially comprise receiving means 3 for insertion of a flash memory card 4 as well as a Winamp tool 5 for decompression of the data stored on the flash memory card 4. In addition to these special components 1 and 2, the conventional components 6, 7 of traditional audio units are provided. These components include, besides the components that are illustrated - since they are externally visible - such as volume control 6 and headphones 7, also battery, processor module, D/A converter and signal processing. The conventional components interact, alternatively, with the specific components 1 or 2. They are utilized in both modes of operation of the audio unit, namely CD operation or MP3 operation, as a result of which a multi-purpose unit that is cost-effective and convenient to transport can be realized.

The invention is not restricted to the embodiment example specified above. Rather, a number of variants are conceivable which, even when designed in a fundamentally different way, make use of the features of the invention.

## Claims

1. Portable audio unit with several components (6, 7), in particular battery, processor, input means and loudspeaker,
characterized in that
at least two audio functions are provided which are realized, in part, by the same components (6, 7).

2. Audio unit according to Claim 1, characterized in that Walkman and MP3-player functions are provided by way of audio functions.

3. Audio unit according to Claim 1, characterized in that mobile-phone and MP3-player functions are provided by way of audio functions.

4. Audio unit according to one of the preceding claims, characterized by receiving means (3) for insertion of a flash memory card (4) and matching means for decompression of the data stored on the flash memory card (4) into a format that is capable of being played back.
